Europäisches Patentamt

European Patent Office

Office européen des brevets

(11) Veröffentlichungsnummer: **0 322 006**
**A2**

## (12) EUROPÄISCHE PATENTANMELDUNG

(21) Anmeldenummer: 88202662.8

(22) Anmeldetag: 24.11.88

(51) Int. Cl.⁴: **G01N 24/08**

(30) Priorität: 25.11.87 DE 3739856

(43) Veröffentlichungstag der Anmeldung:
28.06.89 Patentblatt 89/26

(84) Benannte Vertragsstaaten:
**DE FR GB NL**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB NL**

(72) Erfinder: **McKinnon, Graeme Colin, Dr.**
**Höschgasse 62**
**CH-8008 Zürich(CH)**
Erfinder: **Bösiger, Peter, Dr.**
**Rebbergstrasse 73**
**CH-5400 Ennetbaden(CH)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) Kernresonanz-Spektroskopieverfahren.

(57) Die Erfindung betrifft ein Kernresonanz- Spektroskopieverfahren bei dem auf einen Untersuchungsbereich eine Sequenz - vorzugsweise mehrmals - einwirkt, die einen ersten binomialen 90°-Hochfrequenzimpuls, gefolgt von einem 180°-Hochfrequenzimpuls umfaßt. Ein getrennter Nachweis von entweder Milchsäure oder Lipiden bei Anwesenheit von Wasser wird dadurch möglich, daß dem nicht selektivem 180°-Hochfrequenzimpuls ein zweiter binomialer 90°-Hochfrequenzimpuls folgt und daß die zeitlichen Abstände der beiden binomialen Hochfrequenzimpulse von dem 180°-Hochfrequenzimpuls einander gleich sind und zumindest annähernd dem Kehrwert des Vierfachen der skalaren Kopplungskonstante von Milchsäure entsprechen.

Fig. 4

## Kernresonanz- Spektroskopieverfahren

Die Erfindung betrifft ein Kernresonanz- Spektroskopieverfahren, bei dem auf einen Untersuchungsbereich eine Sequenz - vorzugsweise mehrmals - einwirkt, die einen ersten frequenzselektiven 90°-Hochfrequenzimpuls zur Wasserunterdrückung, gefolgt von einem 180°-Hochfrequenzimpuls umfaßt. sowie eine Vorrichtung zur Durchführung dieses Verfahrens.

Ein solches Verfahren ist aus dem "Book of Abstracts" der S.M.R.M., Vol.3, 1986, Seiten 981 und 982 bekannt. Dabei werden durch den als Binomial-Impuls ausgebildeten frequenzselektiven 90°-Hochfrequenzimpuls die an Wasser gebundenen Protonen praktisch nicht angeregt - jedoch die an Milchsäure gebundenen Protonen. Infolgedessen gelingt der Nachweis von Milchsäure in biologischen Geweben, obwohl das durch Wasser bedingte Signal drei bis vier Zehnerpotenzen größer ist als das durch Milchsäure bedingte Signal - falls der 90° Hochfrequenzimpuls kein Binomial-Impuls ist.

Der 180°-Hochfrequenzimpuls im Anschluß an den ersten binomialen 90°-Hochfrequenzimpuls dient dazu, zusammen mit zwei weiteren 180°-Hochfrequenzimpulsen - jeweils in Verbindung mit einem magnetischen Gradientenfeld - ein Volumenelement zu selektieren und so in Verbindung mit dem binomialen Hochfrequenzimpuls den Milchsäuregehalt in diesem Volumenelement zu bestimmen.

Das bekannte Verfahren wurde an einem Milchsäurephantom erprobt. In der klinischen Praxis ist der Nachweis von Milchsäure jedoch wesentlich schwieriger, weil in dem Frequenzbereich, in dem die Milchsäuresignale auftreten, auch Signal von Lipiden erzeugt werden.

Aufgabe der vorliegenden Erfindung ist es, das Verfahren der Eingangs genannten Art so auszugestalten, daß in Anwesenheit von Wasser der getrennte Nachweis von entweder Milchsäure bzw. Laktat oder Lipiden möglich wird.

Diese Aufgabe wird erfindungsgemäß dadurch gelöst, daß dem nicht selektivem 180°-Hochfrequenzimpuls ein zweiter frequenzselektiver 90°-Hochfrequenzimpuls zur Wasseranregung folgt, und daß die zeitlichen Abstände der beiden Hochfrequenzimpulse von dem 180°-Hochfrequenzimpuls einander gleich sind und zumindest annähernd dem Kehrwert des Vierfachen der skalaren Kopplungskonstante von Milchsäure entsprechen.

Nach dem ersten frequenzselektiven 90° Hochfrequenzimpuls ergeben sich neben dem stark geschwächten Wassersignal Signalkomponenten, die vom Gehalt sowohl an Lipiden als auch an Milchsäure im Untersuchungsbereich abhängen. Nach dem zweiten frequenzselektiven Hochfrequenzimpuls ist entweder die von den Lipiden herrührende Komponente unterdrückt (falls der zweite binomiale Hochfrequenzimpuls die gleiche Phasenlage hat wie der erste) oder die Milchsäurekomponente (falls sich die Phase der beiden binomialen Hochfrequenzimpulse um 90° unterscheidet).

Eine Weiterbildung der Erfindung sieht vor, daß dem zweiten frequenzselektiven Hochfrequenzimpuls drei 180°-Hochfrequenzimpulse in Anwesenheit jeweils eines magnetischen Gradienten-Feldes folgen und daß die Gradienten der während dieser 180° Hochfrequenzimpulse wirksamen magnetischen Gradientenfelder senkrecht zuein ander stehen. Damit ist es möglich, ein bestimmtes Volumen zu selektieren und nur für diesen Volumenbereich den Gehalt an Lipiden oder Milchsäure zu bestimmen.

In weiterer Ausgestaltung der Erfindung ist vorgesehen, daß dem ersten frequenzselektiven Hochfrequenzimpuls ein schmalbandiger 90°-Hochfrequenzimpuls mit einer der Larmorfrequenz von Wasser entsprechenden Frequenz vorausgeht und daß zwischen diesem Hochfrequenzimpuls und dem ersten binomialen Hochfrequenzimpuls zur Dephasierung ein magnetisches Gradientenfeld eingeschaltet wird. Dadurch wird die vom Wasser im Untersuchungsbereich herrührende Signalkomponente noch weiter unterdrückt.

Eine andere Ausgestaltung der Erfindung sieht vor, daß bei jeder zweiten Sequenz der zwischen den beiden frequenzselektiven Hochfrequenzimpulsen liegende 180°-Hochfrequenzimpuls invertiert wird. Dadurch werden die Fehler korrigiert, die durch Ungenauigkeiten des 180°-Hochfrequenzimpulses entstehen (d.h. dadurch, daß die Kernmagnetisierung durch den genannten Impuls nicht überall um exakt 180° gekippt wird).

Die Erfindung wird nachstehend an Hand der Zeichnungen näher erläutert. Es zeigen:

Figur 1 ein Gerät für medizinische Kernresonanzuntersuchunungen, mit dem das erfindungsgemäße Verfahren durchführbar ist,

Figur 2 ein Blockschaltbild eines solchen Gerätes.

Figur 3 die Lage der Spektralkomponenten von Wasser, Milchsäure und Lipiden,

Figur 4 den zeitlichen Verlauf einer ersten Ausführungsform der erfindungsgemäßen Sequenz und

Figur 5 den zeitlichen Verlauf der Hochfrequenzimpulse und der magnetischen Gradientenfelder bei einer zweiten Ausführungsform.

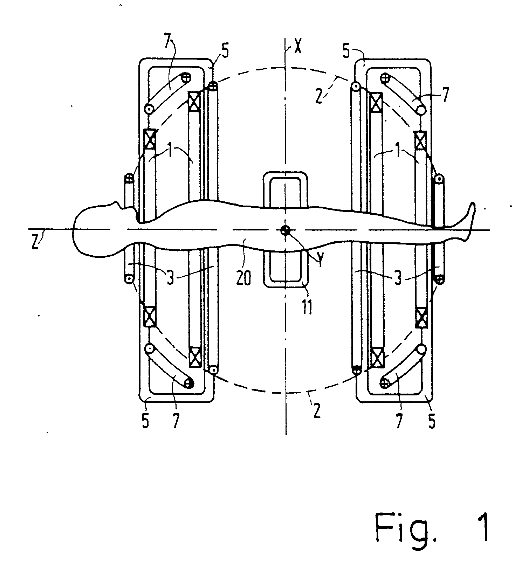

Das in Figur 1 schematisch dargestellte Kernspin-Untersuchungsgerät enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die die gleiche Form haben können wie die Spulen 7, die jedoch diesen gegenüber um 90° versetzt angeordnet sind. Von diesen vier Spulen sind in Figur 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen. xyz-Koordinatensystems bildet, nur durch das stationäre homogene Magnetfeld der Spulenanordnung 1 bestimmt. Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. Im Anschluß an eine Sequenz dient die Hochfrequenzspule 11 oder eine gesonderte Hochfrequenz- Empfangsspule zum Empfangen der im Untersuchungsbereich erzeugten Kernresonanzsignale.

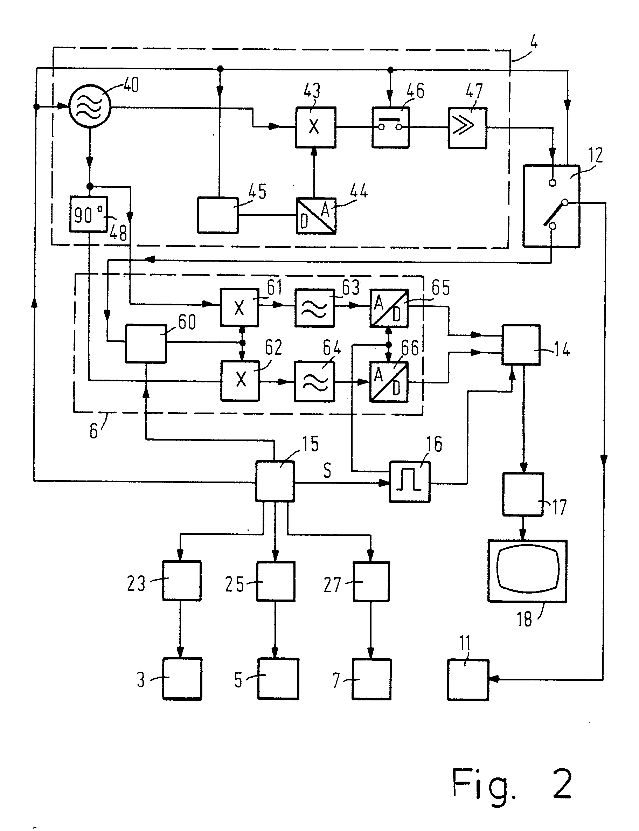

Figur 2 zeigt ein vereinfachtes Blockschaltbild dieses Kernspin-Untersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

.Der Hochfrequenzgenerator 4 enthält einen in seiner· Frequenz durch eine Steuereinheit 15 digital steuerbaren Hochfrequenzoszillator 40, der Schwingungen mit einer Frequenz entsprechend der Larmorfrequenz der anzuregenden Atomkerne bei der von den Spulen 1 erzeugten Feldstärke liefert. Die Larmorfrequenz f berechnet sich bekanntlich nach der Beziehung $f = cB$, wobei B die magnetische ·Induktion in dem stationären homogenen Magnetfeld darstellt und c das gyromagnetische Verhältnis, das beispielsweise für Protonen 42,56 MHz/T beträgt. Der Ausgang des gang des Oszillators 40 ist mit einem Eingang einer Mischstufe 43 verbunden. Der Mischstufe wird ein zweites Eingangssignal von einem Digital-Analog-Wandler 44 zugeführt, dessen Ausgang mit einem digitalen Speicher 45 verbunden ist. Aus dem Speicher wird - gesteuert durch die Steuereinrichtung - eine Folge von .ein Hüllkurvensignal darstellenden digitalen Datenworten ausgelesen.

Die Mischstufe 43 verarbeitet die ihr zugeführten Eingangssignale so, daß sie an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem die in der Hochfrequenzspule 11 induzierten Kernresonanzsignale zugeführt werden, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90° Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben wwerden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die im Speicher 14 gespeicherten Datenworte werden einem Rechner 17 zugeführt, der daraus durch eine diskrete Fourier-Transformation das Spektrum der Kernmagnetisierung ermittelt und an einer geeigneten Wiedergabeeinheit, z.B. einem Monitor 18, ausgibt.

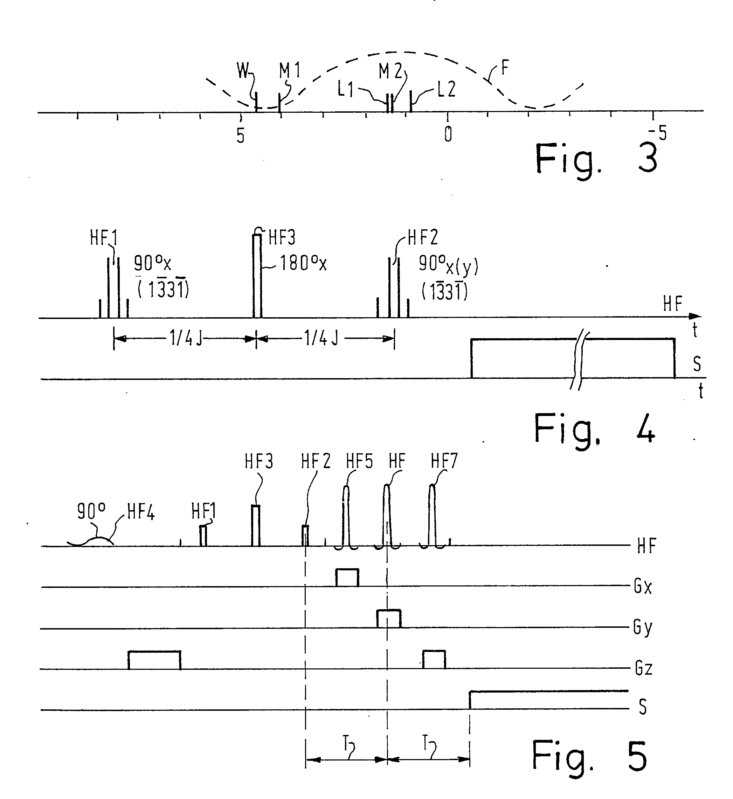

Figur 3 zeigt die Lage der für die klinische Untersuchung wesentlichen Komponenten auf einer Frequenzskala, die die auf die Larmorfrequenz von TMS (Tetramethylsilan) normierte Frequenzabweichung gegenüber der Larmorfrequenz von TMS angibt. Die Larmorfrequenz von TMS liegt dabei also bei Null während die Larmorfrequenz W von Wasser bei 4,7 ppm liegt. Die beiden miteinander gekoppelten Komponenten M1 und M2 der $CH_3$-Gruppe von Milchsäure bzw. Laktat liegen bei 4,1 ppm bzw. bei 1,3 ppm, während die entsprechenden Komponenten L1 und L2 der Lipide bei 1,4 und 0,9 ppm liegen.

Auf der ersten Zeile von Figur 4 ist der zeitliche Verlauf der Hochfrequenzimpulse bei einer erfindungsgemäßen Sequenz dargestellt. Die Sequenz beginnt mit einem frequenzselektiven Hochfrequenzimpuls zur Wasserunterdrückung in Form eines binomialen 90°-Hochfrequenzimpulses HF1. Ein binomialer Hochfrequenzimpuls besteht bekanntlich aus einer Folge von Teilpulsen, deren zugeordnete Flipwinkel im gleichen Verhältnis zueinander stehen wie die Binomial-Koeffizienten, wobei jeder Hochfrequenzimpuls die Kernmagnetisierung mitentgegengesetztem Drehsinn dreht wie der vorausgehende Hochfrequenzimpuls. Im Ausführungsbeispiel nach Figur 4 ist der erste binomiale Hochfrequenzimpuls HF1 ein sogenannter 1 $\overline{3}$ 3 $\overline{1}$ -Hochfrequenzimpuls. Dem ersten und dem letzten Teilpuls dieses binomialen Hochfrequenzimpulses ist dabei ein Flipwinkel von 11,25° zugeordnet, während der zweite und der dritte Teilpuls einen Flipwinkel von 33,75° aufweisen. Wenn die Frequenz des Oszillators 40 exakt der Larmorfrequenz von Wasser entspricht, wird durch einen solchen binomialen Hochfrequenzimpuls die Wasserkomponente im Untersuchungsbereich praktisch nicht angeregt.

Außer der Wasserkomponente werden all die Komponenten im Untersuchungsbereich praktisch nicht angeregt, deren Larmorfrequenzen in einem definiertem Abstand von der Larmorfrequenz von Wasser - oder einem ganzzahligen Vielfachen davon liegen. Auf die Komponenten, deren Lamorfrequenzen in der Mitte zwischen der praktisch unterdrückten Larmorfrequenzen liegt, wirkt ein solcher binomialer Hochfrequenzimpuls wie ein 90°-Impuls. Der erwähnte Frequenzabstand ist durch den zeitlichen Abstand der Teilpulse bestimmt. Er entspricht dem doppelten des Kehrwertes des zeitlichen Abstandes zweier aufeinanderfolgender Teilpulse. Bei einer magnetischen Induktion von 1,5 T beträgt die Frequenzdifferenz zwischen den Frequenz komponenten W und M2 etwa 217 Hz und das Doppelte davon 434 Hz. Der Kehrwert von 434 Hz entspricht etwa 2,3 ms. Wenn demgemäß die Teilpulse des ersten binomialen Hochfrequenzimpulses HF1 einen Abstand von 2,3 ms voneinander haben, wird einerseits die Wasserkomponente W und die ihr benachbarte Milchsäurekomponente M1 praktisch nicht angeregt, während die Kernmagnetisierung der zweiten Milchsäurekomponente M2, aber auch der beiden miteinander gekoppelten Lipidkomponenten L1, L2 um 90° gekippt wird. In Figur 3 ist dies durch die gestrichelte Kurve F angedeutet.

Nach dem ersten binomialen 90°-Hochfrequenzimpuls HF1 sind also die Komponenten M2, L1 und L2, aber auch die von den $CH_2$-Gruppen in den Lipiden herrührenden und in der Nachbarschaft von M2 befindlichen, miteinander nicht gekoppelten Komponenten angeregt.

Nach dem ersten binomialen Hochfrequenzimpuls HF1 folgt ein 180°-Hochfrequenzimpuls HF3, der die Kernmagnetisierung (in einem mit der Larmorfrequenz mitrotierenden Koordinatensystem) um die gleiche Achse kippt wie der erste und der dritte Teilpuls von HF1. Der Hochfrequenzimpuls HF3 ist ein sogenannter "harter" Impuls, d.h. er hat (infolge seiner kurzen Dauer) eine relativ große Bandbreite, so daß alle Wasserstoffprotonen im Untersuchungsbereich unabhängig von ihrer chemischen Bindung davon beeinflußt werden. Der Hochfrequenzimpuls HF3 folgt auf den Hochfrequenz HF1 in einem zeitlichen Abstand gleich dem Kehrwert des vierfachen der skalaren Kopplungskonstante J von Milchsäure. Da diese Konstante einen Wert von knapp 7 Hz hat, resultiert daraus ein zeitlicher Abstand von rund 35 ms (gemessen von der zeitlichen Mitte des Impulses HF1 bis zur zeitlichen Mitte des Impulses HF3).

Mit dem gleichen zeitlichen Abstand folgt dem 180°-Hochfrequenzimpuls HF3 ein zweiter binomialer Hochfrequenzimpuls HF2. Die Teilpulse haben den gleichen Abstand voneinander und die gleiche Amplitude wie die Teilpulse des ersten binomialen Hochfrequenzimpulses HF1. Wesentlich ist dabei die Phasenlage des Impulses:

Wenn die Phasenlage der Teilpulse des binomialen Hochfrequenzimpulses HF2 derjenigen der Teilpulse von HF1 entspricht, werden alle Signale unterdrückt, die von den in Figur 3 nicht näher dargestellten nicht gekoppelten Lipidkompcnenten im Frequenzbereich von M2 herrühren. Außerdem werden die gekoppelten Komponenten L1 und L2 in einen Mehrfach-Quantenkohärenz-Zustand überführt, in dem sie keine beobachtbaren Signale liefern können. Lediglich die Milchsäurekomponente M2 wird, weil die mit ihr gekoppelte Milchsäurekomponente M1 durch den ersten binomialen Hochfrequenzimpuls HF1 praktisch nicht angeregt ist, in einen Einfach-Quantenkohärenz-Zustand überführt, in dem sie ein beobachtbares Signal liefert. Somit kann bei dieser Phasenlage des zweiten Hochfrequenzimpulses HF2 das Vorhandensein bzw. die Konzentration von Milchsäure im Untsuchungsbesreich bestimmt werden. Zu diesem Zweck wird im Anschluß an den zweiten binomialen Hochfrequenzimpuls der Umschalter 12 (vergl. Figur 2) in die in der Zeichnung dargestellte Stellung umgeschaltet und durch ein Signal S der Taktimpulsgenerator freigegeben, so daß das im Untersuchungsbereich erzeugte Kernresonanzsignal in eine Folge von digitalen Datenworten umgesetzt wird. Aus diesen Datenworten wird in bekannter Weise durch Fourier-Transformation das Frequenzspektrum ermittelt.

Wenn die Phasenlage des zweiten binomialen Hochfreqenzimpulses gegenüber der des ersten binomialen Hochfrequenzimpulses HF1 um 90° versetzt ist (d.h. wenn die Kern magnetisierung - in einem mit Larmorfrequenz mitrotierenden Koordinatensystem - um eine Achse gekippt wird, die mit der Kippachse von HF1 einen Winkel von 90° aufweist), werden die Milchsäurekomponente M2 und die miteinander gekoppelten Lipidkomponenten L1 und L2 in einen Quantenkohärenz-Zustand überführt, in dem sie kein beobachtbares Signal liefern. Die nicht miteinander gekoppelten Lipidkomponenten im Bereich von M2 werden durch den zweiten binomialen Hochfrequenzimpuls HF2 praktisch nicht beeinflußt und liefern daher ein Kernresonanzsignal, das in gleicher Weise ausgewertet wird, wie zuvor erläutert. Somit ist bei dieser Phasenlage ein Nachweis der Lipiden im Untersuchungsbereich möglich.

Um die gegenüber HF1 um 90° versetzte Phasenlage von HF2 zu erzeugen, ist es lediglich erforderlich bei HF2 die Phasenlage des Oszillatorssignals um 90° zu drehen. Dies könnte dadurch erfolgen, daß an Stelle des Ausgangssignals des Oszillators 40 das Ausgangssignal des 90°-Phasendrehgliedes 48 dem Eingang des Mischers 43 zugeführt wird. Stattdessen kann aber auch - gesteuert durch die Steuereinheit 15 - die Oszillatorfrequenz solange variiert werden, bis sich gegenüber der ursprünglichen Oszillatorschwingung eine Phasenverschiebung von 90° ergibt.

Die in Fig. 4 dargestellte Sequenz ermöglicht die Bestimmung des Milchsäure- oder Lipidgehaltes nur innerhalb des gesamten Untersuchungsbereiches. In vielen Fällen ist es aber erwünscht, den Milchsäuregehalt oder den Lipidgehalt in einem beschränkten Bereich des Untersuchungsbereiches, d.h. in einer bestimmten Körperregion des im Untersuchungsbereich befindlichen Patienten, durchzuführen. Weiterhin läßt sich in der Praxis mit einer Sequenz nach Figur 4, das Wassersignal (d.h. das Kernresonanzsignal, daß durch die Anregung der Kernspins von Wasser entsteht) nicht vollständig unterdrücken; vielmehr ist das resultierende Wassersignal noch immer wesentlich größer als das Milchsäure- oder Lipidsignal.

Gemäß Fig. 5 wird daher vor Beginn einer Sequenz ein "weicher" 90°-Hochfrequenzimpuls HF4 eingeschaltet. Dieser Impuls hat eine relativ große Dauer, woraus eine relativ geringe Bandbreite resultiert, derart daß im gesamten Untersuchungsbereich zunächst nur die Wasserkomponente W, angeregt wird, aber nicht die Komponenten L1, L2 und M2. Nach dem Hochfrequenzimpuls HF4, aber vor dem Hochfrequenzimpuls HF1 wird ein magnetisches Gradientenfeld Gz (3 Zeile, Figur 5) eingeschaltet, das die Kernmagnetisierung dephasiert. Das hat zur Folge, daß die Wasserkomponente in dem durch die Hochfrequenzimpulse HF1..HF3 angeregten Spektrum noch weiter unterdrückt wird. Dieser, der eigentlichen Anregung vorangehende Teil der Sequenz ist aber überflüssig, wenn die Wasserkomponente schon durch die Sequenz selbst genügend unterdrückt wird.

Nach dem zweiten binomialen Hochfrequenzimpuls HF2 werden noch drei selektive 180°-Hochfrequenzimpulse HF5, HF6 und HF7 eingeschaltet. Während jedes dieser Hochfrequenzimpulse ist ein magnetisches Gradientenfeld eingeschaltet, wobei die Richtung des magnetischen Gradientfeldes von Impuls zu Impuls um 90° gedreht wird (vergl. Zeilen 2 bis 4). Diese drei Hochfrequenzimpulse haben den gleichen Abstand voneinander, der - im Gegensatz zu der Darstellung zu Fig. 5 - wesentlich kleiner sein kann als der Abstand zu der vorausgegangenen Sequenz. Wie im einzelnen in der deutschen Patentanmeldung P 37 25 800.1 erläutert, werden dadurch alle Kernresonanzssignale unterdrückt, die nicht aus einem durch die Frequenz und die Bandbreite der Hochfrequenzimpulse sowie die Größe und Dauer des magnetischen Gradientenfeldes bestimmten Volumenbereich stammen. Dies ermöglicht es also, durch Fouriertransformation des im Anschluß an diese drei Impulse abgetasteten Kernresonanzsignals (vergl. Zeile 5 von Figur 5) entweder den Milchsäure- oder den Lipidgehalt in einer definierten Körperregion, beispielsweise einem Teil des Gehirns, zu bestimmen. Die besten Resultate werden dabei erzielt, wenn der zeitliche Abstand T von der Mitte des zweiten binomialen Hochfrequenzimpulses HF2 bis zur Mitte des mittleren Impulses HF6 der drei Impulse der Bedingung

$$T = (n + 1\,2)\,2\,J$$

genügt, wobei n eine ganze Zahl ist, und wenn der Abstand zwischen HF6 und dem Abtastintervall ebenfalls T ist".

In der Praxis ist der Hochfrequenzimpuls HF3 kein idealer 180°-Impuls, d.h. die Größe des Flipwinkels beträgt nicht überall im Untersuchungsbereich bzw. in dem selektierten Volumenbereich 180°. Dadurch ergeben sich Fehler in dem aus der Messung resultierenden Spektrum. Diese Messung, bei der die Sequenz nach Figur 5 viele Male, zum Beispiel 128 mal wiederholt wird, wobei die resultierenden Kernresonanzsignale addiert werden und erst das Kernresonanz- Summensignal einer Fouriertransformation unterzogen wird, kann dadurch korrigiert werden, daß in jeder zweiten Sequenz der 180°-Hochfrequenzimpuls HF3 jeweils mit entgegengesetztem Drehsinn gekippt wird. Dazu muß die zeitliche Phase des Oszillatorsignals von Sequenz zu Sequenz um 180° springen. Dies kann auf verschiedene Weise erreicht werden, beispielsweise dadurch, daß in jeder zweiten Sequenz das Hüllkurvensignal aus dem Speicher 14 mit dem Faktor - 1 mulitipliziert wird oder dadurch, daß vor den Hochfrequenzimpulsen HF3 die Frequenz solange geändert wird, bis sich eine Phasenverschiebung von 180° ergeben hat. Ebenso ist es aber auch möglich, einen Oszillator zu verwenden, der neben einem invertierenden Ausgang einen nicht invertierenden Ausgang besitzt und die beiden Ausgänge von Sequenz zu Sequenz abwechselnd mit dem Eingang der Mischschaltung 43 zu verbinden.

Die Erfindung wurde vorstehend in Verbindung mit binomialen 90°-Hochfrequenzimpulsen HF1 und HF2 erläutert. Jedoch können an ihrer Stelle auch andere frequenzselektive Impulse verwendet werden, die die an Wasser gebundenen Wasserstoffprotonen im Untersuchungsbereich nicht anregen, beispielsweise sog. DANTE-Impulse (vgl. Morris et al in J.Magn.Reson., 29, S. 433, (1978)).

## Ansprüche

1. Kernresonanz- Spektroskopieverfahren bei dem auf einen Untersuchungsbereich eine Sequenz - vorzugsweise mehrmals - einwirkt, die einen ersten frequenzselektiven 90°-Hochfrequenzimpuls zur Wasserunterdrückung, gefolgt von einem 180°-Hochfrequenzimpuls umfaßt, dadurch gekennzeichnet, daß dem nicht selektivem 180°-Hochfrequenzimpuls (HF3) ein zweiter frequenzselektiver 90°-Hochfrequenzimpuls zur Wasserunterdrückung (HF2) folgt und daß die zeitlichen Abstände der beiden frequenzselektiven Hochfrequenzimpulse (HF1,HF2) von dem 180°-Hochfrequenzimpuls (HF3) einander gleich sind und zumindest annähernd dem Kehrwert des Vierfachen der skalaren Kopplungskonstante J von Milchsäure entsprechen.

2. Verfahren nach Anspruch 1, dadurch gekennzeichnet, daß zum Nachweis von Milchsäure die beiden frequenzselektiven Hochfrequenzimpulse (HF1, HF2) die gleiche Phasenlage aufweisen.

3. Verfahren nach Anspruch 1, dadurch gekennzeichnet, daß zum Nachweis von Lipiden die Phasenlagen der beiden frequenzselektiven Hochfrequenzimpulse (HF1, HF2) um 90° gegeneinander versetzt sind.

4. Verfahren nach einem der vorhergehenden Ansprüche, dadurch gekennzeichnet, daß dem zweiten frequenzselektiven Hochfrequenzimpuls drei 180°-Hochfrequenzimpulse (HF5..HF7) in Anwesenheit jeweils eines magnetischen Gradienten-Feldes (Gx..Gz) folgen und daß die Gradienten der während dieser 180° Hochfrequenzimpulse wirksamen magnetischen Gradientenfelder senkrecht zueinander stehen.

5. Verfahren nach einem der vorhergehenden Ansprüche, dadurch gekennzeichnet, daß dem ersten frequenzselektiven Hochfrequenzimpuls (HF1) ein schmalbandiger 90°-Hochfrequenzimpuls (HF4) mit einer der Larmorfrequenz von Wasser entsprechenden Frequenz vorausgeht und daß zwischen diesem Hochfrequenzimpuls und dem ersten binomialen Hochfrequenzimpuls (HF1) zur Dephasierung ein magnetisches Gradientenfeld (Gz) eingeschaltet wird.

6. Verfahren nach einem der vorhergehenden Ansprüche, dadurch gekennzeichnet, daß bei jeder zweiten Sequenz der zwischen den beiden frequenzselektiven Hochfrequenzimpulsen liegende 180° Hochfrequenzimpuls (HF3) invertiert wird.

7. Verfahren nach einem der Ansprüche 1-6, dadurch gekennzeichnet, daß die beiden selektiven Hochfrequenzimpulse binomiale Hochfrequenzimpulse sind.

8. Verfahren nach Anspruch 4, dadurch gekennzeichnet, daß der zeitliche Abstand T zwischen der Mitte des zweiten selektiven Hochfrequenzimpulses (HF2) und der Mitte des zweiten (HF6) der drei Hochfrequenzimpulse (HF5, HF6, HF7) der Bedingung genügt:

$T = (n + 1/2)/2 J,$

wobei n eine positive ganze Zahl ist, und daß das zur Zeit T nach dem zweiten (HF6) der drei Hochfrequenzimpulse auftretende Kernresonanzsignal erfaßt und weiterverarbeitet wird.

9. Vorrichtung zur Durchführung des Verfahrens nach Anspruch 1, mit Mitteln (1) zur Erzeugung eines homogenen stationären Magnetfeldes, mit einer Hochfrequenzspulenan ordnung (11) zum Erzeugen von Hochfrequenzimpulsen und zum Aufnehmen der Reaktion darauf im Untersuchungsbereich erzeugten Kernresonanzsignale, einer Verarbeitungseinheit (17) zum Ableiten eines Spektrums aus den aufgenommenen Kernresonanzsignalen und mit einer Steuereinheit (15),
dadurch gekennzeichnet, daß die Steuereinheit (15) so ausgebildet ist, daß sie mindestens eine Sequenz erzeugt,bei der auf einen ersten frequenzselektiven 90°-Hochfrequenzimpuls zur Wasserunterdrückung (HF1) ein 180°-Hochfrequenzimpuls folgt, dem seinerseits ein zweiter frequenzselektiver 90°-Hochfrequenzimpuls zur Wasserunterdrückung folgt, wobei die zeitlichen Abstände zwischen den beiden binomialen Hochfrequenzimpulsen und dem 180°-Hochfrequenzimpuls einander gleich sind und annähernd dem Kehrwert des Vierfachen der skalaren Kopplungskonstante J von Milchsäure entsprechen.

Fig. 1

Fig. 2

## Fig. 3

Labels on curve: W, M1, L1, M2, L2, F

Axis values: 5, 0, -5

## Fig. 4

HF1 — 90°x (1$\bar{3}3\bar{1}$)

HF3 — 180°x

HF2 — 90°x(y) (1$\bar{3}3\bar{1}$)

1/4 J — 1/4 J

HF, t, S, t

## Fig. 5

HF3, HF2, HF5, HF, HF7

90° HF4, HF1

HF, Gx, Gy, Gz, S

$T_2$, $T_2$